# EUROPÄISCHE PATENTSCHRIFT

(11) **EP 3 370 071 B1**
(45) Veröffentlichungstag und Bekanntmachung des Hinweises auf die Patenterteilung: **27.07.2022**
(21) Anmeldenummer: 18155755.4
(22) Anmeldetag: 08.02.2018
(51) Int. Cl.: G01R 15/18, H01F 38/30, H01F 27/38

(54) **STROMWANDLEREINRICHTUNG**
CURRENT TRANSDUCER DEVICE
DISPOSITIF FORMANT TRANSFORMATEUR DE COURANT

(30) Priorität: 02.03.2017 DE 102017104350
(43) Veröffentlichungstag der Anmeldung: 05.09.2018
(73) Patentinhaber: GMC-I Messtechnik GmbH, 90449 Nürnberg (DE)
(72) Erfinder: Hiltner, Heinz, 90592 Schwarzenbruck (DE); Winterholler, Christoph, 90449 Nürnberg (DE); Keller, Roman, 90425 Nürnberg (DE)
(74) Vertreter: Hafner & Kohl PartmbB

(56) Entgegenhaltungen:
- EP-A1- 0 670 498
- EP-A1- 2 924 450
- EP-A2- 2 700 953
- FR-A1- 2 679 037
- JP-A- S58 219 721
- JP-A- 2003 329 711
- US-A1- 2011 116 197

## Beschreibung

Die Erfindung betrifft eine Stromwandlereinrichtung, umfassend ein ringartig oder ringförmig ausgebildetes Kernelement sowie wenigstens ein einen Teil einer Wicklungsanordnung bildendes Wicklungselement, wobei das wenigstens eine Wicklungselement das Kernelement zumindest abschnittsweise, insbesondere vollständig, umgibt.

Derartige Stromwandlereinrichtungen sind dem Grunde nach bekannt. Entsprechende Stromwandlereinrichtungen dienen im Sinne eines Messwandlers der Messung von elektrischen Strömen, was typischerweise durch Wandlung eines Primärstroms in einen zu dem Primärstrom (im Wesentlichen) proportionalen Sekundärstrom erfolgt. Der Sekundärstrom lässt sich als Messsignal von der Stromwandlereinrichtung abgreifen.

Untersuchungen zeigten, dass der Betrieb entsprechender Stromwandlereinrichtungen, d. h. die Messgenauigkeit von zu messenden Strömen, durch externe magnetische Felder ("Störfelder"), welche z. B. von einem benachbart zu einer jeweiligen Stromwandlereinrichtung angeordneten Transformator erzeugt werden können, negativ beeinflusst werden kann. Ist eine Stromwandlereinrichtung zusätzlich in einem entsprechenden Störfeld angeordnet - bei annähernd homogenem Störfeld und homogener Beschaffenheit des der jeweiligen Stromwandlereinrichtung zugehörigen, von wenigstens einem Wicklungselement umgebenen Kernelements - teilt sich der magnetische Fluss in dem Kernelement gleich auf. Da aufgrund einer vergleichsweise niederohmigen Shunt-Einrichtung als weiterem Bestandteil einer jeweiligen Stromwandlereinrichtung in dem Kernelement, d. h. insbesondere in einem der Shunt-Einrichtung zugewandten Abschnitt des Kernelements, ein Strom induziert wird, enthält das von der Stromwandlereinrichtung abgreifbare Messsignal einen Störanteil, der auf das das Kernelement umgebende Wicklungselement übertragen wird.

EP 2 924 450 A1 offenbart ein Beispiel für eine Stromwandlereinrichtung, die ein Kompensationselement enthält .

Der Erfindung liegt die Aufgabe zugrunde, eine demgegenüber, insbesondere im Hinblick auf die Kompensation des Einflusses entsprechender Störfelder auf den Betrieb der Stromwandlereinrichtung, verbesserte Stromwandlereinrichtung anzugeben.

Die Aufgabe wird durch eine Stromwandlereinrichtung gemäß Anspruch 1 gelöst. Die hierzu abhängigen Ansprüche betreffen mögliche Ausführungsformen der Stromwandlereinrichtung gemäß Anspruch 1.

Die hierin beschriebene Stromwandlereinrichtung dient im Allgemeinen im Sinne eines Messwandlers der Messung von elektrischen Strömen, was typischerweise durch Wandlung eines Primärstroms in einen zu dem Primärstrom (im Wesentlichen) proportionalen Sekundärstrom erfolgt. Der Sekundärstrom lässt sich als Messsignal von der Stromwandlereinrichtung abgreifen.

Die Stromwandlereinrichtung umfasst ein ringartig bzw. ringförmig ausgebildetes Kernelement ("Ringkern"). Das Kernelement kann ein- oder mehrteilig ausgebildet sein; insbesondere kann das Kernelement aus mehreren unter Ausbildung der ringartigen bzw. -förmigen geometrischen Gestalt des Kernelements miteinander verbindbaren bzw. verbundenen Bogenelementen ausgebildet sein. Das Kernelement bzw. entsprechende Bogenelemente ist bzw. sind typischerweise aus einem magnetischen, insbesondere ferromagnetischen, Material, wie z. B. Ferrit, gebildet.

Die Stromwandlereinrichtung umfasst weiterhin wenigstens ein einen Teil einer Wicklungsanordnung ("Sekundärwicklungsanordnung") bildendes Wicklungselement ("Sekundärwicklungselement"). Das wenigstens eine Wicklungselement umgibt das Kernelement zumindest abschnittsweise, insbesondere vollständig. Mit anderen Worten ist das Kernelement zumindest abschnittsweise, insbesondere vollständig, von wenigstens einem einen Teil einer Wicklungsanordnung bildenden Wicklungselement, typischerweise gleichförmig bzw. -mäßig, umgeben bzw. umwickelt bzw. umwunden. Bei dem Wicklungselement handelt es sich typischerweise um einen aus einem elektrisch leitfähigen Material, insbesondere einem Metall, beispielsweise Kupfer, gebildeten Draht. Der das Kernelement sonach typischerweise durch Wicklung bzw. Windung umgebende Draht ist vergleichsweise dünn und in einer Vielzahl an Wicklungen bzw. Windungen, d. h. z. B. 1000 Windungen, um das Kernelement gewickelt bzw. gewunden, sodass die Wicklungsanordnung typischerweise, insbesondere im Verhältnis zu einer Primärwicklung der Stromwandlereinrichtung, vergleichsweise hochohmige Eigenschaften aufweist. Wenn im Weiteren von einem Kernelement die Rede ist, ist hierunter stets ein von wenigstens einem einen Teil einer Wicklungsanordnung bildenden Wicklungselement umgebenes bzw. umwickeltes bzw. umwundenes Kernelement zu verstehen.

Zur Kompensation entsprechender Störfelder, welche, wie im Zusammenhang mit dem eingangs geschilderten Stand der Technik erläutert ist, z. B. von einem benachbart zu der Stromwandlereinrichtung angeordneten Transformator erzeugt werden können, umfasst die Stromwandlereinrichtung ein ringartig bzw. ringförmig ausgebildetes Kompensationselement. Das Kompensationselement ist entsprechend zur Kompensation von auf die Stromwandlereinrichtung einwirkenden, insbesondere magnetischen, Störfeldern eingerichtet. Das Kompensationselement kann daher als Kompensationswindung bezeichnet oder erachtet werden. Bei dem Kompensationselement handelt es sich typischerweise um einen aus einem elektrisch leitfähigen Material, insbesondere einem Metall, beispielsweise Kupfer, gebildeten Draht.

Das Kompensationselement ist, das Kernelement innen- und außenumfangsseitig ringartig bzw. -förmig umgebend, sich entlang des Innen- und des Außenumfangs des Kernelements erstreckend relativ zu dem Kernelement angeordnet. Das Kompensationselement ist dabei in einer definierten räumlichen Anordnung relativ zu dem Kernelement angeordnet. Wie sich im Weiteren ergibt, ist das Kompensationselement typischerweise in einer zu einem Shuntelement der Stromwandlereinrichtung gleichen bzw. geringfügig verschobenen parallelen Ebene angeordnet.

Das Kompensationselement kann z. B. am Außen- oder Innenumfang des Kernelements oder, insbesondere vermittels eines, z. B. plattenartigen, Halterungselements, im Bereich des Außen- oder Innenumfangs des Kernelements angeordnet bzw. befestigt sein. Alternativ oder ergänzend kann das Kompensationselement an einer Stirnseite des Kernelements oder, insbesondere vermittels eines, z. B. plattenartigen, Halterungselements, im Bereich einer Stirnseite des Kernelements angeordnet bzw. befestigt sein. Das Kompensationselement kann sonach unmittelbar an dem Kernelement (bzw. der Wicklungsanordnung) angeordnet bzw. befestigt sein. Denkbar ist jedoch auch, dass das Kompensationselement an einem, z. B. plattenartigen, Halterungselement im Bereich des Außen- oder Innenumfangs bzw. im Bereich einer Stirnseite des Kernelements angeordnet bzw. befestigt ist, in welchem Fall kein unmittelbarer Kontakt zwischen dem Kompensationselement und dem Kernelement bestehen muss. In allen Fällen besteht zwischen dem Kompensationselement und dem Kernelement (bzw. der Wicklungsanordnung) keine galvanische Verbindung.

Die Ringebene des Kompensationselements, d. h. die Raumebene, in welcher sich das Kompensationselement räumlich erstreckt, ist typischerweise rechtwinklig zu der Ringebene des Kernelements, d. h. die Raumebene, in welcher sich das Kernelement räumlich erstreckt, angeordnet. Die Ringebene des Kompensationselements ist im Montagezustand der Stromwandlereinrichtung typischerweise horizontal ausgerichtet, die Ringebene des Kernelements ist im Montagezustand der Stromwandlereinrichtung dagegen typischerweise vertikal ausgerichtet. Kernelement und Kompensationselement können, wenngleich sich diese in ihren konkreten geometrischen Abmessungen typischerweise unterscheiden, aufgrund ihrer Anordnung relativ zueinander als Glieder einer Rundgliederkette erachtet werden. Wie sich im Weiteren ergibt, ist das Kompensationselement typischerweise (im Wesentlichen) in einer Ebene und damit um 180° versetzt zu dem Stromzuführbereich der Stromwandlereinrichtung, über welchen der Primärstrom in die Stromwandlereinrichtung einkoppelbar ist ("Strom-Einkoppelzweig"), angeordnet bzw. ausgerichtet.

Eine entsprechende Anordnung eines Kompensationselements ermöglicht eine effiziente und zuverlässige Kompensation des Einflusses entsprechender Störfelder auf den Betrieb der Stromwandlereinrichtung. Diese ergibt sich insbesondere aus der besonderen Anordnung des Kompensationselements relativ zu dem Kernelement, welche es ermöglicht, dass der Fluss durch die durch eine Shunt-Einrichtung der Stromwandlereinrichtung gebildete Primärwindung entgegengesetzt dem Fluss durch das Kompensationselement ist. Mithin liegt eine insbesondere im Hinblick auf die Kompensation des Einflusses entsprechender Störfelder auf den Betrieb der Stromwandlereinrichtung verbesserte Stromwandlereinrichtung vor.

Das Kompensationselement kann durch mehrere, d. h. insbesondere vier, Kompensationselementabschnitte gebildet sein bzw. mehrere, d. h. insbesondere vier, Kompensationselementabschnitte umfassen. Die Kompensationselementabschnitte sind unter Ausbildung des Kompensationselements miteinander verbunden. Da das Kompensationselement typischerweise einstückig ausgebildet ist, kann es sich bei entsprechenden Kompensationselementabschnitten um bestimmte Abschnitte, insbesondere Längserstreckungsabschnitte, des einstückig ausgebildeten Kompensationselements handeln, welche sich in ihrer räumlichen Anordnung und/oder Ausrichtung unterscheiden.

Ein bzw. der erste(r) Kompensationselementabschnitt kann sich in axialer Richtung bezüglich der Zentralachse des Kernelements entlang des Innenumfangs des Kernelements erstreckend ausgebildet bzw. ausgerichtet sein. Der erste Kompensationselementabschnitt ist typischerweise zwischen einen zweiten und einen vierten Kompensationselementabschnitt geschaltet, d. h. (einends) mit einem zweiten und (andernends) einem vierten Kompensationselementabschnitt verbunden.

Ein bzw. der von dem ersten Kompensationselementabschnitt ausgehende(r) zweite(r) Kompensationselementabschnitt kann sich in radialer Richtung bezüglich der Zentralachse des Kernelements zwischen dem Innen- und dem Außenumfang des Kernelements erstreckend ausgebildet bzw. ausgerichtet sein. Der zweite Kompensationselementabschnitt ist typischerweise zwischen den ersten und den dritten Kompensationselementabschnitt geschaltet, d. h. (einends) mit dem ersten und (andernends) dem dritten Kompensationselementabschnitt verbunden.

Ein bzw. der von dem zweiten Kompensationselementabschnitt ausgehende(r) dritte(r) Kompensationselementabschnitt kann sich in axialer Richtung bezüglich der Zentralachse des Kernelements entlang des Außenumfangs des Kernelements erstreckend ausgebildet bzw. ausgerichtet sein. Der dritte Kompensationselementabschnitt ist typischerweise zwischen den zweiten und den vierten Kompensationselementabschnitt geschaltet, d. h. (einends) mit dem zweiten und (andernends) dem vierten Kompensationselementabschnitt verbunden.

Ein bzw. der von dem dritten Kompensationselementabschnitt ausgehende(r) vierte(r) Kompensationselementabschnitt kann sich in radialer Richtung bezüglich der Zentralachse des Kernelements zwischen dem Außen- und dem Innenumfang des Kernelements erstreckend ausgebildet bzw. ausgerichtet sein. Der vierte Kompensationselementabschnitt ist typischerweise zwischen den dritten und den ersten Kompensationselementabschnitt geschaltet, d. h. (einends) mit dem dritten und (andernends) dem ersten Kompensationselementabschnitt verbunden.

Aus vorstehenden Ausführungen zu den Kompensationselementabschnitten ergibt sich, dass der erste und der dritte Kompensationselementabschnitt sich typischerweise (im Wesentlichen) parallel zueinander erstreckend ausgebildet bzw. ausgerichtet sind, da sich diese jeweils in axialer Richtung bezüglich der Zentralachse des Kernelements entlang des Innen- bzw. Außenumfangs des Kernelements erstrecken.

Aus vorstehenden Ausführungen zu den Kompensationselementabschnitten ergibt sich weiter, dass die Kompensationselementabschnitte sich typischerweise in einer gemeinsamen Ebene erstreckend ausgebildet bzw. ausgerichtet sind. Bei der gemeinsamen Ebene handelt es sich um die weiter oben bereits erwähnte Ringebene des Kompensationselements, d. h. die Raumebene, in welcher sich das Kompensationselement räumlich erstreckt.

Wie erwähnt, kann das Kompensationselement z. B. am Außen- oder Innenumfang des Kernelements oder, insbesondere vermittels eines, z. B. plattenartigen, Halterungselements, im Bereich des Außen- oder Innenumfangs des Kernelements angeordnet bzw. befestigt sein oder an einer Stirnseite des Kernelements oder, insbesondere vermittels eines Halterungselements, im Bereich einer Stirnseite des Kernelements angeordnet bzw. befestigt sein. Die Befestigung des Kompensationselements am oder im Bereich des Außenumfangs des Kernelements kann über den dritten Kompensationselementabschnitt erfolgen, die Befestigung des Kompensationselements am oder im Bereich des Innenumfangs des Kernelements kann über den ersten Kompensationselementabschnitt erfolgen. Die Befestigung des Kompensationselements an einer oder im Bereich einer Stirnseite des Kernelements kann über den zweiten und/oder den vierten Kompensationselementabschnitt erfolgen. In allen Fällen kann eine Befestigung des Kompensationselements vermittels wenigstens eines Befestigungspunkts, bei welchem es sich z. B. um einen Klebepunkt handeln kann, erfolgen.

Aufgrund der Befestigung kann der erste oder der dritte Kompensationselementabschnitt zumindest abschnittsweise, gegebenenfalls vollständig, unmittelbar am Außen- oder Innenumfang des Kernelements anliegen. Dagegen können die anderen Kompensationselementabschnitte sichjeweils mit einem gewissen Abstand zu dem Kernelement erstreckend angeordnet bzw. ausgebildet sein, sodass diese das Kernelement (jeweils) nicht berühren.. Analoges gilt für die stirnseitige Anordnung des Kompensationselements.

Wie erwähnt, umfasst die Stromwandlereinrichtung typischerweise eine Shunt-Einrichtung. Die Shunt-Einrichtung kann ein U-artig bzw. U-förmig ausgebildetes erstes Shuntelement umfassen. Das erste Shuntelement ist sich abschnittsweise durch den durch den Innenumfang des Kernelements definierten Innenraum erstreckend ausgebildet. Das erste Shuntelement ist typischerweise aus einer Widerstandslegierung, insbesondere einer Kupfer-Nickel-Mangan-Legierung, bevorzugt einer unter dem Handelsnamen "Manganin" erhältlichen Kupfer-Nickel-Mangan-Legierung, gebildet. Die elektrischen Eigenschaften der Widerstandslegierung und somit des Shuntelements sind zweckmäßig (weitgehend) temperaturunabhängig. Das erste Shuntelement kann als "Nebenshunt" bezeichnet bzw. erachtet werden.

Das erste Shuntelement kann durch mehrere, d. h. insbesondere drei, Shuntelementabschnitte gebildet sein bzw. mehrere, d. h. insbesondere drei, Shuntelementabschnitte umfassen. Die Shuntelementabschnitte sind unter Ausbildung des ersten Shuntelements miteinander verbunden. Da das erste Shuntelement typischerweise einstückig ausgebildet ist, kann es sich bei entsprechenden Shuntelementabschnitten um bestimmte Abschnitte, insbesondere Längserstreckungsabschnitte, des einstückig ausgebildeten ersten Shuntelements handeln, welche sich in ihrer räumlichen Anordnung und/oder Ausrichtung unterscheiden.

Ein bzw. das von einem ersten Stromführungselement als weiterem Bestandteil der Stromwandlereinrichtung ausgehende(r) erste(r) Shuntelementabschnitt kann sich radial bezüglich der Zentralachse des Kernelements in Richtung des Innenumfangs des Kernelements erstreckend ausgebildet bzw. ausgerichtet sein. Der erste Shuntelementabschnitt ist typischerweise zwischen das erste Stromführungselement und einen zweiten Shuntelementabschnitt geschaltet, d. h. (einends) mit dem ersten Stromführungselement und (andernends) dem zweiten Shuntelementabschnitt verbunden.

Ein bzw. der von dem ersten Shuntelementabschnitt ausgehende(r) zweite(r) Shuntelementabschnitt kann sich in axialer Richtung bezüglich der Zentralachse des Kernelements erstreckend durch den durch den Innenumfang des Kernelements definierten Innenraum erstreckend ausgebildet bzw. ausgerichtet sein. Der zweite Shuntelementabschnitt ist typischerweise zwischen den ersten Shuntelementabschnitt und einen dritten Shuntelementabschnitt geschaltet, d. h. (einends) mit dem ersten Shuntelementabschnitt und (andernends) dem dritten Shuntelementabschnitt verbunden.

Ein bzw. der von dem zweiten Shuntelementabschnitt ausgehende(r) dritte(r) Shuntelementabschnitt kann sich radial bezüglich der Zentralachse des Kernelements in Richtung des Außenumfangs des Kernelements erstreckend ausgebildet bzw. ausgerichtet sein. Der dritte Shuntelementabschnitt ist typischerweise zwischen den zweiten Shuntelementabschnitt und ein zweites Stromführungselement geschaltet, d. h. (einends) mit dem zweiten Shuntelementabschnitt und (andernends) dem zweiten Stromführungselement verbunden.

Jeweilige Verbindungsbereiche zwischen jeweiligen Shuntelementabschnitten, d. h. insbesondere zwischen dem ersten und dem zweiten Shuntelementabschnitt sowie zwischen dem zweiten und dem dritten Shuntelementabschnitt, können gebogen oder gewinkelt verlaufend ausgebildet sein.

Aus vorstehenden Ausführungen zu den Shuntelementabschnitten ergibt sich, dass der erste und der dritte Shuntelementabschnitt typischerweise im Wesentlichen parallel zueinander erstreckend ausgebildet bzw. ausgerichtet sind, da sich diese jeweils in radialer Richtung bezüglich der Zentralachse des Kernelements erstrecken.

Aus vorstehenden Ausführungen zu den Shuntelementabschnitten ergibt sich weiter, dass die Shuntelementabschnitte sich typischerweise in einer gemeinsamen Ebene erstreckend ausgerichtet sind. Wie erwähnt, sind typischerweise auch die das Kompensationselement bildenden Kompensationselementabschnitte sich in einer gemeinsamen Ebene erstreckend ausgerichtet. Um die Kompensationswirkung des Kompensationselements nicht zu beeinträchtigen bzw. weiter zu verbessern, können bzw. sollten die Kompensationselementabschnitte und die Shuntelementabschnitte sich in einer gemeinsamen Ebene oder in parallelen Ebenen erstreckend ausgerichtet sein. Sämtliche Kompensationselementabschnitte und sämtliche Shuntelementabschnitte können bzw. sollten sonach in einer gemeinsamen Ebene oder in parallelen Ebenen angeordnet sein. Eine derartige Anordnung wirkt sich positiv auf die Kompensationswirkung des Kompensationselements aus.

Die Shunt-Einrichtung kann ein einen weiteren Teil der Shunt-Einrichtung bildendes weiteres Shuntelement umfassen. Das weitere Shuntelement kann zwischen den beiden mit dem ersten Shuntelement verbundenen Stromführungselementen angeordnet sein. Das weitere Shuntelement ist typischerweise aus einer Widerstandslegierung, insbesondere einer Kupfer-Nickel-Mangan-Legierung, bevorzugt einer unter dem Handelsnamen "Manganin" erhältlichen Kupfer-Nickel-Mangan-Legierung, gebildet. Das weitere Shuntelement kann als "Hauptshunt" bezeichnet bzw. erachtet werden.

Das erste Shuntelement und das weitere Shuntelement können eine das Kernelement innenseitig, d. h. den durch den Innenumfang des Kernelements definierten Innenraum, durchsetzende Shuntwindung bilden. Das erste und das weitere Shuntelement bilden sonach eine komplette Shuntwindung um das Kernelement.

Der elektrische Widerstand des Kompensationselements entspricht typischerweise dem elektrischen Widerstand der Shuntwindung. Derart lässt sich eine Kompensation eines durch die Shunt-Einrichtung bzw. die Shuntwindung "eingefangenen" Störsignals durch ein durch das Kompensationselement "eingefangenen" gleichen oder ähnlichen Störsignals realisieren. Reihenschaltung der Shunt-Einrichtung zu dem Kompensationselement realisieren. Eine derartige Anordnung wirkt sich positiv auf die Kompensationswirkung des Kompensationselements aus. An dieser Stelle ist jedoch anzumerken, dass im Allgemeinen gegebenenfalls eine Nachjustierung des Abgleichbereichs der Stromwandlereinrichtung vorzunehmen ist, um die durch das Kompensationselement bewirkte Dämpfung des Messsignals auszugleichen.

Die Erfindung ist anhand von Ausführungsbeispielen in den Zeichnungsfiguren näher erläutert. Dabei zeigt:

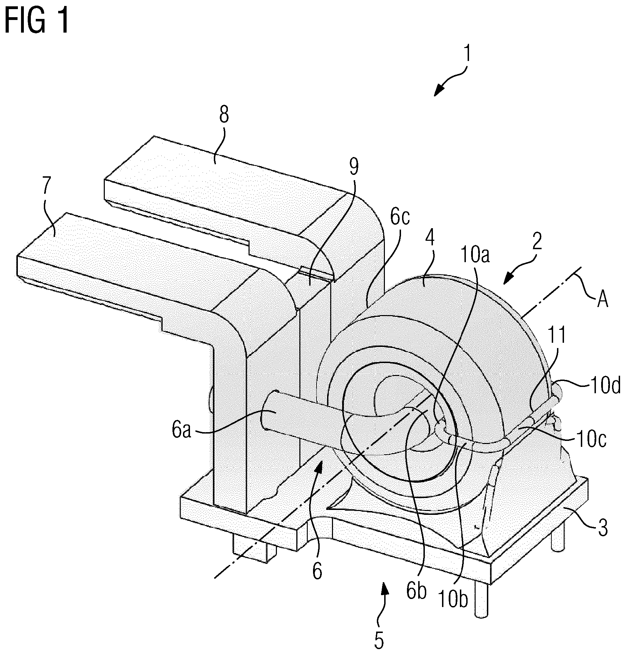

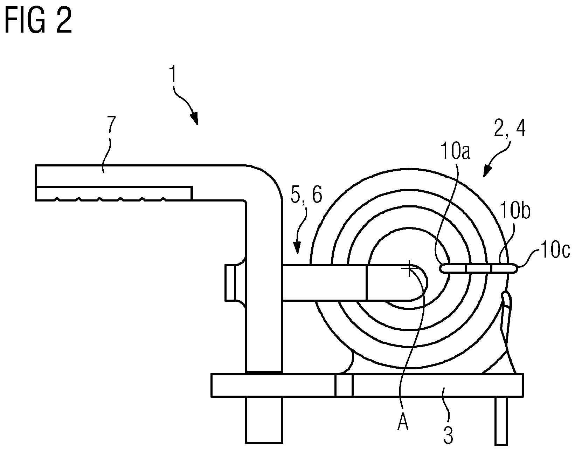

- Fig. 1, 2: je eine Prinzipdarstellung einer Stromwandlereinrichtung gemäß einem Ausführungsbeispiel.

Die Fig. 1, 2 zeigen jeweils eine Prinzipdarstellung einer Stromwandlereinrichtung 1 gemäß einem Ausführungsbeispiel. Die Stromwandlereinrichtung 1 ist in Fig. 1 in einer perspektivischen Ansicht und in Fig. 2 in einer seitlichen Ansicht dargestellt.

Die Stromwandlereinrichtung 1 dient im Sinne eines Messwandlers der Messung von elektrischen Strömen. Die Messung elektrischer Ströme erfolgt durch Wandlung eines Primärstroms in einen zu dem Primärstrom (im Wesentlichen) proportionalen Sekundärstrom, welcher sich als Messsignal von der Stromwandlereinrichtung 1 abgreifen lässt.

Die Stromwandlereinrichtung 1 umfasst ein ringartig bzw. ringförmig ausgebildetes Kernelement 2 ("Ringkern"). Das auf einem Substrat 3, d. h. typischerweise einer Leiterplatte angeordnete, Kernelement 2 kann ein- oder mehrteilig ausgebildet sein; insbesondere kann das Kernelement 2 aus mehreren unter Ausbildung der ringartigen bzw. -förmigen geometrischen Gestalt des Kernelements 2 miteinander verbindbaren bzw. verbundenen Bogenelementen (nicht gezeigt) ausgebildet sein. Das Kernelement 2 bzw. entsprechende Bogenelemente ist bzw. sind aus einem magnetischen, insbesondere ferromagnetischen, Material, wie z. B. Ferrit, gebildet.

Die Stromwandlereinrichtung 1 umfasst weiterhin wenigstens ein einen Teil einer Wicklungsanordnung 4 ("Sekundärwicklungsanordnung") bildendes, nicht näher bezeichnetes Wicklungselement ("Sekundärwicklungselement"). Die Wicklungsanordnung 4 bzw. das wenigstens eine Wicklungselement umgibt das Kernelement 2 vollständig. Das Kernelement 2 ist damit von dem wenigstens einen einen Teil der Wicklungsanordnung 4 bildenden Wicklungselement, typischerweise gleichförmig bzw. -mäßig, umgeben bzw. umwickelt bzw. umwunden.

Bei dem Wicklungselement handelt es sich um einen aus einem elektrisch leitfähigen Material, nämlich einem Metall, beispielsweise Kupfer, gebildeten Draht. Der Draht ist vergleichsweise dünn, die Drahtstärke kann z. B. ca. 0,05 mm betragen, und in einer Vielzahl an Wicklungen bzw. Windungen, d. h. z. B. 1000 Windungen, um das Kernelement 2 gewickelt bzw. gewunden, sodass die Wicklungsanordnung 4 vergleichsweise hochohmige Eigenschaften aufweist. Wenn im Weiteren von einem Kernelement 2 die Rede ist, ist hierunter stets ein von wenigstens einem einen Teil der Wicklungsanordnung 4 bildenden Wicklungselement umgebenes bzw. umwickeltes bzw. umwundenes Kernelement 2 zu verstehen.

Die Stromwandlereinrichtung 1 umfasst weiterhin eine Shunt-Einrichtung 5. Die Shunt-Einrichtung 5 umfasst ein U-artig bzw. U-förmig ausgebildetes erstes Shuntelement 6. Das erste Shuntelement 6 ist sich abschnittsweise durch den durch den Innenumfang des Kernelements 2 definierten Innenraum erstreckend ausgebildet. Das erste Shuntelement 6 ist aus einer Widerstandslegierung, insbesondere einer Kupfer-Nickel-Mangan-Legierung, bevorzugt einer unter dem Handelsnamen "Manganin" erhältlichen Kupfer-Nickel-Mangan-Legierung, gebildet. Das erste Shuntelement 6 kann als "Nebenshunt" bezeichnet bzw. erachtet werden.

Das erste Shuntelement 6 ist durch mehrere, d. h. insbesondere drei, Shuntelementabschnitte 6a - 6c gebildet. Die Shuntelementabschnitte 6a - 6c sind unter Ausbildung des ersten Shuntelements 6 miteinander verbunden.

Da das erste Shuntelement 6 typischerweise einstückig ausgebildet ist, handelt es sich bei entsprechenden Shuntelementabschnitten 6a - 6c um bestimmte Abschnitte, insbesondere Längserstreckungsabschnitte, des ersten Shuntelements 6, welche sich in ihrer räumlichen Anordnung und/oder Ausrichtung unterscheiden.

Ein von einem in dem Ausführungsbeispiel winklig ausgebildeten ersten Stromführungselement 7 als weiterem Bestandteil der Stromwandlereinrichtung 1 ausgehender erster Shuntelementabschnitt 6a ist sich radial bezüglich der Symmetrie- bzw. Zentralachse A des Kernelements 2 in Richtung des Innenumfangs des Kernelements 2 erstreckend ausgebildet bzw. ausgerichtet. Ersichtlich ist der erste Shuntelementabschnitt 6a zwischen das erste Stromführungselement 7 und einen zweiten Shuntelementabschnitt 6b geschaltet, d. h. (einends) mit dem ersten Stromführungselement 7 und (andernends) dem zweiten Shuntelementabschnitt 6b verbunden.

Ein von dem ersten Shuntelementabschnitt 6a ausgehender zweiter Shuntelementabschnitt 6b ist sich in axialer Richtung bezüglich der Zentralachse A des Kernelements 2 durch den durch den Innenumfang des Kernelements 2 definierten Innenraum erstreckend ausgebildet bzw. ausgerichtet. Ersichtlich ist der zweite Shuntelementabschnitt 6b zwischen den ersten Shuntelementabschnitt 6a und einen dritten Shuntelementabschnitt 6c geschaltet, d. h. (einends) mit dem ersten Shuntelementabschnitt 6a und (andernends) dem dritten Shuntelementabschnitt 6c verbunden.

Ein von dem zweiten Shuntelementabschnitt 6b ausgehender dritter Shuntelementabschnitt 6c ist sich radial bezüglich der Zentralachse A des Kernelements 2 in Richtung des Außenumfangs des Kernelements 2 erstreckend ausgebildet bzw. ausgerichtet. Ersichtlich ist der dritte Shuntelementabschnitt 6c zwischen den zweiten Shuntelementabschnitt 6b und ein in dem Ausführungsbeispiel winklig ausgebildetes zweites Stromführungselement 8 geschaltet, d. h. (einends) mit dem zweiten Shuntelementabschnitt 6b und (andernends) dem zweiten Stromführungselement 8 verbunden.

Aus Fig. 1 ergibt sich, dass jeweilige Verbindungsbereiche (nicht näher bezeichnet) zwischen jeweiligen Shuntelementabschnitten 6a - 6c, d. h. insbesondere zwischen dem ersten und dem zweiten Shuntelementabschnitt 6a, 6b sowie zwischen dem zweiten und dem dritten Shuntelementabschnitt 6b, 6c, z. B. gebogen verlaufend ausgebildet sein können.

Aus vorstehenden Ausführungen zu den Shuntelementabschnitten 6a - 6c sowie aus den Fig. ergibt sich, dass der erste und der dritte Shuntelementabschnitt 6a, 6c sich im Wesentlichen parallel zueinander erstreckend ausgebildet bzw. ausgerichtet sind, da sich diese jeweils in radialer Richtung bezüglich der Zentralachse A des Kernelements 2 erstrecken.

Aus vorstehenden Ausführungen zu den Shuntelementabschnitten 6a - 6c sowie aus den Fig. ergibt sich weiter, dass die Shuntelementabschnitte 6a - 6c sich in einer gemeinsamen Ebene erstreckend ausgerichtet sind.

Die Shunt-Einrichtung 5 umfasst zudem ein weiteres Shuntelement 9. Das weitere Shuntelement 9 ist zwischen den beiden mit dem ersten Shuntelement 6 verbundenen Stromführungselementen 7, 8 angeordnet. Auch das weitere Shuntelement 9 ist aus einer Widerstandslegierung, insbesondere einer Kupfer-Nickel-Mangan-Legierung, bevorzugt einer unter dem Handelsnamen "Manganin" erhältlichen Kupfer-Nickel-Mangan-Legierung, gebildet. Das weitere Shuntelement 9 kann als "Hauptshunt" bezeichnet bzw. erachtet werden.

Insbesondere anhand von Fig. 1 ist ersichtlich, dass das erste Shuntelement 6 und das weitere Shuntelement 9 eine das Kernelement 2 innenseitig, d. h. den durch den Innenumfang des Kernelements 2 definierten Innenraum, durchsetzende Shuntwindung bilden. Das erste und das weitere Shuntelement 6, 9 bilden eine komplette Shuntwindung um das Kernelement 2.

Zur Kompensation von Störfeldern, welche z. B. von einem benachbart zu der Stromwandlereinrichtung 1 angeordneten Transformator (nicht gezeigt) erzeugt werden können, umfasst die Stromwandlereinrichtung 1 ein ringartig bzw. ringförmig ausgebildetes Kompensationselement 10. Das Kompensationselement 10 ist entsprechend zur Kompensation von auf die Stromwandlereinrichtung 1 einwirkenden, insbesondere magnetischen, Störfeldern eingerichtet und kann daher als Kompensationswindung bezeichnet oder erachtet werden. Bei dem Kompensationselement 10 handelt es sich um einen aus einem elektrisch leitfähigen Material, insbesondere einem Metall, beispielsweise Kupfer, gebildeten Draht.

Anhand der Fig. ist ersichtlich, dass das Kompensationselement 10 das Kernelement 2 innen- und außenumfangsseitig ringartig bzw. -förmig umgebend, sich entlang des Innen- und des Außenumfangs des Kernelements 2 erstreckend relativ zu dem Kernelement 2 angeordnet und vermittels wenigstens eines Befestigungspunkts 11, d. h. z. B. eines Klebepunkts, beispielhaft am Außenumfang des Kernelements 2 befestigt ist. Die Ringebene des Kompensationselements 10, d. h. die Raumebene E1, in welcher sich das Kompensationselement 10 räumlich erstreckt, ist rechtwinklig zu der Ringebene des Kernelements 2, d. h. die Raumebene E2, in welcher sich das Kernelement 2 räumlich erstreckt, angeordnet (vgl. insbesondere Fig. 2). Die Ringebene des Kompensationselements 10 ist im Montagezustand der Stromwandlereinrichtung 1 horizontal ausgerichtet, die Ringebene des Kernelements 2 ist im Montagezustand der Stromwandlereinrichtung 1 vertikal ausgerichtet. Kernelement 2 und Kompensationselement 10 können, wenngleich sich diese in ihren konkreten geometrischen Abmessungen unterscheiden, aufgrund ihrer Anordnung relativ zueinander als Glieder einer Rundgliederkette erachtet werden.

Ersichtlich ist das Kompensationselement 10 (im Wesentlichen) um 180° versetzt zu dem durch die Stromführungselemente 7, 8 gebildeten Stromzuführbereich der Stromwandlereinrichtung 1, über welchen der Primärstrom in die Stromwandlereinrichtung 1 einkoppelbar ist ("Strom-Einkoppelzweig"), angeordnet bzw. ausgerichtet.

Der elektrische Widerstand des Kompensationselements 10 entspricht dem elektrischen Widerstand der Shuntwindung. Derart lässt sich eine Kompensation eines durch die Shunt-Einrichtung 5 bzw. die Shuntwindung "eingefangenen" Störsignals durch ein durch das Kompensationselement 10 "eingefangenen" Störsignals realisieren.

Das Kompensationselement 10 ist durch mehrere, d. h. insbesondere vier, Kompensationselementabschnitte 10a - 10d gebildet. Die Kompensationselementabschnitte 10a - 10d sind unter Ausbildung des Kompensationselements 10 miteinander verbunden. Da das Kompensationselement 10 typischerweise einstückig ausgebildet ist, kann es sich bei den Kompensationselementabschnitten 10a - 10d um bestimmte Abschnitte, insbesondere Längserstreckungsabschnitte, des Kompensationselements 10 handeln, welche sich in ihrer räumlichen Anordnung und/oder Ausrichtung unterscheiden.

Ein erster Kompensationselementabschnitt 10a ist sich in axialer Richtung bezüglich der Zentralachse A des Kernelements 2 entlang des Innenumfangs des Kernelements 2 erstreckend ausgebildet bzw. ausgerichtet. Der erste Kompensationselementabschnitt 10a ist zwischen einen zweiten und einen vierten Kompensationselementabschnitt 10a, 10d geschaltet, d. h. (einends) mit dem zweiten Kompensationselementabschnitt 10b und (andernends) dem vierten Kompensationselementabschnitt 10d verbunden.

Ein von dem ersten Kompensationselementabschnitt 10a ausgehender zweiter Kompensationselementabschnitt 10b ist sich in radialer Richtung bezüglich der Zentralachse A des Kernelements 2 zwischen dem Innen- und dem Außenumfang des Kernelements 2 erstreckend ausgebildet bzw. ausgerichtet. Der zweite Kompensationselementabschnitt 10b ist zwischen den ersten und den dritten Kompensationselementabschnitt 10a, 10c geschaltet, d. h. (einends) mit dem ersten Kompensationselementabschnitt 10a und (andernends) dem dritten Kompensationselementabschnitt 10c verbunden.

Ein von dem zweiten Kompensationselementabschnitt 10b ausgehender dritter Kompensationselementabschnitt 10c ist sich in axialer Richtung bezüglich der Zentralachse A des Kernelements 2 entlang des Außenumfangs des Kernelements 2 erstreckend ausgebildet bzw. ausgerichtet. Der dritte Kompensationselementabschnitt 10c ist zwischen den zweiten und den vierten Kompensationselementabschnitt 10b, 10d geschaltet, d. h. (einends) mit dem zweiten Kompensationselementabschnitt 10b und (andernends) dem vierten Kompensationselementabschnitt 10d verbunden.

Ein von dem dritten Kompensationselementabschnitt 10c ausgehender vierter Kompensationselementabschnitt 10d ist sich in radialer Richtung bezüglich der Zentralachse A des Kernelements 2 zwischen dem Außen- und dem Innenumfang des Kernelements 2 erstreckend ausgebildet bzw. ausgerichtet. Der vierte Kompensationselementabschnitt 10d ist zwischen den dritten und den ersten Kompensationselementabschnitt 10c, 10a geschaltet, d. h. (einends) mit dem dritten Kompensationselementabschnitt 10c und (andernends) dem ersten Kompensationselementabschnitt 10a verbunden.

Aus vorstehenden Ausführungen zu den Kompensationselementabschnitten 10a - 10d sowie anhand der Fig. ergibt sich, dass der erste und der dritte Kompensationselementabschnitt 10a, 10c sich (im Wesentlichen) parallel zueinander erstreckend ausgebildet bzw. ausgerichtet sind, da sich diese jeweils in axialer Richtung bezüglich der Zentralachse A des Kernelements 2 entlang des Innen- bzw. Außenumfangs des Kernelements 2 erstrecken.

Aus vorstehenden Ausführungen zu den Kompensationselementabschnitten 10a - 10d sowie anhand der Fig. ergibt sich weiter, dass die Kompensationselementabschnitte 10a - 10d sich in einer gemeinsamen Ebene erstreckend ausgebildet bzw. ausgerichtet sind. Bei der gemeinsamen Ebene handelt es sich um die Ringebene des Kompensationselements 10, d. h. die Raumebene E1, in welcher sich das Kompensationselement 10 räumlich erstreckt.

Insbesondere anhand von Fig. 2 ist ersichtlich dass die Kompensationselementabschnitte 10a- 10d und die Shuntelementabschnitte 6a - 6c sich in einer gemeinsamen Ebene bzw. in parallelen Ebenen erstreckend ausgerichtet sind. Sämtliche Kompensationselementabschnitte 10a - 10d und sämtliche Shuntelementabschnitte 6a - 6c können sonach in einer gemeinsamen Ebene oder in parallelen Ebenen angeordnet sein.

Schließlich ist, wie aus den Fig. ersichtlich, anzumerken, dass in dem Ausführungsbeispiel die Befestigung des Kompensationselements 10 an dem Außenumfang des Kernelements 2 über den dritten Kompensationselementabschnitt 10c erfolgt. Mithin ist das Kompensationselement 10 über den dritten Kompensationselementabschnitt 10c an dem Kernelement 2 befestigt. Wie erwähnt, sind auch andere Befestigungspositionen des Kompensationselements 10 an dem Kernelement 2 möglich. Die Befestigung des Kompensationselements 10 an dem Außenumfang des Kernelements 2 erfolgt vermittels wenigstens eines Befestigungspunkts 11, bei welchem es sich, wie ebenfalls erwähnt, z. B. um einen Klebepunkt handeln kann. Aufgrund der Befestigung liegt der dritte Kompensationselementabschnitt 10c unmittelbar am Außenumfang des Kernelements 2 bzw. der Wicklungsanordnung 4 an. Dagegen sind in dem Ausführungsbeispiel der erste, zweite und vierte Kompensationselementabschnitt 10a, 10b, 10c sich jeweils mit einem gewissen Abstand zu dem Kernelement 2 erstreckend angeordnet bzw. ausgebildet, sodass diese das Kernelement 2 (jeweils) nicht berühren.

In allen Fällen besteht zwischen dem Kompensationselement und dem Kernelement (bzw. der Wicklungsanordnung) keine galvanische Verbindung.

## Patentansprüche

1. Stromwandlereinrichtung (1), umfassend:
- ein ringartig oder -förmig ausgebildetes Kernelement (2),
- wenigstens ein einen Teil einer Wicklungsanordnung (4) bildendes Wicklungselement, wobei das wenigstens eine Wicklungselement das Kernelement (2) zumindest abschnittsweise, insbesondere vollständig, umgibt,
- ein ringartig oder -förmig ausgebildetes Kompensationselement (10), welches zur Kompensation von auf die Stromwandlereinrichtung (1) einwirkenden, insbesondere magnetischen, Störfeldern eingerichtet ist, wobei das Kompensationselement (10) sich, das Kernelement (2) umgebend, entlang des Innen- und des Außenumfangs des Kernelements (2) erstreckend, in einer definierten räumlichen Anordnung relativ zu dem Kernelement (2) angeordnet ist, wobei das Kompensationselement (10) ein aus einem elektrisch leitfähigen Material gebildeter Draht ist, **gekennzeichnet durch**
- ein einen Teil einer Shunt-Einrichtung (5) bildendes, U-artig bzw. -förmig ausgebildetes erstes Shuntelement (6), wobei das erste Shuntelement (6) sich abschnittsweise durch den durch den Innenumfang des Kernelements (2) definierten Innenraum erstreckend ausgebildet ist,
- ein einen weiteren Teil der Shunt-Einrichtung (5) bildendes weiteres Shuntelement (9), wobei das weitere Shuntelement (9) zwischen zwei mit dem ersten Shuntelement (6) verbundenen Stromführungselementen (7, 8) angeordnet ist, wobei
das erste Shuntelement (6) und das weitere Shuntelement (9) eine das von dem wenigstens einen Wicklungselement umgebenen Kernelement (2) innenseitig durchsetzende Shuntwindung bilden, wobei
der elektrische Widerstand des Kompensationselements (10) dem elektrischen Widerstand der Shuntwindung entspricht.

2. Stromwandlereinrichtung nach Anspruch 1, **dadurch gekennzeichnet, dass** das Kompensationselement (10) am Außen- oder Innenumfang oder, insbesondere vermittels eines Halterungselements, im Bereich des Außen- oder Innenumfangs des von dem wenigstens einen Wicklungselement umgebenen Kernelements (2) angeordnet ist oder an einer Stirnseite oder, insbesondere vermittels eines Halterungselements, im Bereich einer Stirnseite des von dem wenigstens einen Wicklungselement umgebenen Kernelements (2) angeordnet ist.

3. Stromwandlereinrichtung nach Anspruch 1 oder 2, **dadurch gekennzeichnet, dass** das Kompensationselement (10) durch mehrere, insbesondere vier, Kompensationselementabschnitte (10a - 10d) gebildet ist, wobei
- ein erster Kompensationselementabschnitt (10a) sich in axialer Richtung bezüglich der Zentralachse (A) des Kernelements (2) entlang des Innenumfangs des Kernelements (2) erstreckend ausgerichtet ist, wobei der erste Kompensationselementabschnitt (10a) mit einem zweiten und einem vierten Kompensationselementabschnitt (10b, 10d) verbunden ist,
- der von dem ersten Kompensationselementabschnitt (10a) ausgehende zweite Kompensationselementabschnitt (10b) sich in radialer Richtung bezüglich der Zentralachse (A) des Kernelements (2) zwischen dem Innen- und dem Außenumfang des Kernelements (2) erstreckend ausgerichtet ist, wobei der zweite Kompensationselementabschnitt (10b) mit dem ersten und einem dritten Kompensationselementabschnitt (10a, 10c) verbunden ist,
- der von dem zweiten Kompensationselementabschnitt (10b) ausgehende dritte Kompensationselementabschnitt (10c) sich in axialer Richtung bezüglich der Zentralachse (A) des Kernelements (2) entlang des Außenumfangs des Kernelements (2) erstreckend ausgerichtet ist, wobei der dritte Kompensationselementabschnitt (10c) mit dem zweiten und dem vierten Kompensationselementabschnitt (10b, 10d) verbunden ist,
der von dem dritten Kompensationselementabschnitt (10c) ausgehende vierte Kompensationselementabschnitt (10d) sich in radialer Richtung bezüglich der Zentralachse (A) des Kernelements (2) zwischen dem Außen- und dem Innenumfang des Kernelements (2) erstreckend ausgerichtet ist, wobei der vierte Kompensationselementabschnitt (10d) mit dem dritten und dem ersten Kompensationselementabschnitt (10a, 10c) verbunden ist.

4. Stromwandlereinrichtung nach Anspruch 3, **dadurch gekennzeichnet, dass** das Kompensationselement (10) über den dritten Kompensationselementabschnitt (10a) an dem Kernelement (2) befestigt ist.

5. Stromwandlereinrichtung nach Anspruch 3 oder 4, **dadurch gekennzeichnet, dass** der erste, zweite und vierte Kompensationselementabschnitt (10a, 10b, 10d) sich jeweils mit einem gewissen Abstand zu dem Kernelement (2) erstreckend ausgebildet sind, wobei diese das Kernelement (2) nicht berühren.

6. Stromwandlereinrichtung nach einem der Ansprüche 3 bis 5, **dadurch gekennzeichnet, dass** der erste und der dritte Kompensationselementabschnitt (10a, 10c) sich parallel zueinander erstreckend ausgerichtet sind.

7. Stromwandlereinrichtung nach einem der Ansprüche 3 bis 6, **dadurch gekennzeichnet, dass** die das Kompensationselement (10) bildenden Kompensationselementabschnitte (10a - 10d) sich in einer gemeinsamen Ebene erstreckend ausgerichtet sind.

8. Stromwandlereinrichtung nach einem der vorhergehenden Ansprüche, **dadurch gekennzeichnet, dass** das erste Shuntelement (6) durch mehrere Shuntelementabschnitte (6a - 6c) gebildet ist, wobei
- ein von einem ersten Stromführungselement (7) ausgehender erster Shuntelementabschnitt (6a) sich radial bezüglich der Zentralachse (A) des Kernelements (2) in Richtung des Innenumfangs des Kernelements (2) erstreckend ausgerichtet ist, wobei der erste Shuntelementabschnitt (6a) mit dem ersten Stromführungselement (7) und einem zweiten Shuntelementabschnitt (6b) verbunden ist,
- ein von dem ersten Shuntelementabschnitt (6a) ausgehender zweiter Shuntelementabschnitt (6b) sich in axialer Richtung bezüglich der Zentralachse (A) des Kernelements (2) durch den durch den Innenumfang des Kernelements (2) definierten Innenraum erstreckend ausgerichtet ist, wobei der zweite Shuntelementabschnitt (6b) mit dem ersten Shuntelementabschnitt (6a) und einem dritten Shuntelementabschnitt (6c) verbunden ist, und
- ein von dem zweiten Shuntelementabschnitt (6b) ausgehender dritter Shuntelementabschnitt (6c) sich radial bezüglich der Zentralachse (A) des Kernelements (2) in Richtung des Außenumfangs des Kernelements (2) erstreckend ausgerichtet ist, wobei der dritte Shuntelementabschnitt (6c) mit dem zweiten Shuntelementabschnitt (6b) und einem zweiten Stromführungselement (8) verbunden ist.

9. Stromwandlereinrichtung nach einem der vorhergehenden Ansprüche, **dadurch gekennzeichnet, dass** die das erste Shuntelement (6) bildenden Shuntelementabschnitte (6a - 6c) sich in einer gemeinsamen Ebene erstreckend ausgerichtet sind.

10. Stromwandlereinrichtung nach Anspruch 7 und 9, **dadurch gekennzeichnet, dass** die das Kompensationselement (10) bildenden Kompensationselementabschnitte (10a - 10d) und die das erste Shuntelement (6) bildenden Shuntelementabschnitte (6a - 6c) sich in einer gemeinsamen Ebene oder in parallelen Ebenen erstreckend ausgerichtet sind.

## Claims

1. Current transformer device (1), comprising:
- a core element (2) which is formed in a ring-like or ring-shaped manner,
- at least one winding element which forms a part of a winding assembly (4), wherein the at least one winding element surrounds the core element (2) at least in portions, in particular completely,
- a compensation element (10) which is formed in a ring-like or ring-shaped manner and which is designed for compensating in particular magnetic interfering fields which act on the current transformer device (1), wherein the compensation element (10) is arranged in a defined spatial arrangement relative to the core element (2), in a manner surrounding the core element (2) and extending along the inner and outer periphery of the core element (2), wherein the compensation element (10) is a wire formed of an electrically conductive material,
**characterized by**
- a first shunt element (6) which is formed in a U-like or U-shaped manner and forms a part of a shunt device (5), wherein the first shunt element (6) is designed so as to extend, in portions, through the internal space defined by the inner periphery of the core element (2),
- a further shunt element (9) which forms a further part of the shunt device (5), wherein the further shunt element (9) is arranged between two current-carrying elements (7, 8) connected to the first shunt element (6), wherein
the first shunt element (6) and the further shunt element (9) form a shunt winding which passes through the core element (2), surrounded by the at least one winding element, on the inside, wherein
the electrical resistance of the compensation element (10) corresponds to the electrical resistance of the shunt winding.

2. Current transformer device according to claim 1, **characterised in that** the compensation element (10) is arranged on the outer or inner periphery or, in particular by means of a retainer element, in the region of the outer or inner periphery of the core element (2) surrounded by the at least one winding element, or is arranged on an end face or, in particular by means of a retainer element, in the region of an end face of the core element (2) surrounded by the at least one winding element.

3. Current transformer device according to either claim 1 or claim 2, **characterised in that** the compensation element (10) is formed by a plurality of, in particular four, compensation element portions (10a - 10d), wherein
- a first compensation element portion (10a) is oriented so as to extend in the axial direction with respect to the central axis (A) of the core element (2), along the inner periphery of the core element (2), wherein the first compensation element portion (10a) is connected to a second and a fourth compensation element portion (10b, 10d),
- the second compensation element portion (10b) proceeding from the first compensation element portion (10a) is oriented so as to extend in the radial direction with respect to the central axis (A) of the core element (2), between the inner and the outer periphery of the core element (2), wherein the second compensation element portion (10b) is connected to the first and a third compensation element portion (10a, 10c),
- the third compensation element portion (10c) proceeding from the second compensation element portion (10b) is oriented so as to extend in the axial direction with respect to the central axis (A) of the core element (2), along the outer periphery of the core element (2), wherein the third compensation element portion (10c) is connected to the second and the fourth compensation element portion (10b, 10d),
- the fourth compensation element portion (10d) proceeding from the third compensation element portion (10c) is oriented so as to extend in the radial direction with respect to the central axis (A) of the core element (2), between the outer and the inner periphery of the core element (2), wherein the fourth compensation element portion (10d) is connected to the third and the first compensation element portion (10a, 10c).

4. Current transformer device according to claim 3, **characterised in that** the compensation element (10) is fastened to the core element (2) by means of the third compensation element portion (10a).

5. Current transformer device according to either claim 3 or claim 4, **characterised in that** the first, second and fourth compensation element portion (10a, 10b, 10d) are each designed to as to extend at a certain distance from the core element (2), wherein they do not touch the core element (2).

6. Current transformer device according to any of claims 3 to 5, **characterised in that** the first and the third compensation element portion (10a, 10c) are oriented so as to extend in parallel with one another.

7. Current transformer device according to any of claims 3 to 6, **characterised in that** the compensation element portions (10a - 10d) forming the compensation element (10) are oriented so as to extend in a common plane.

8. Current transformer device according to any of the preceding claims, **characterised in that** the first shunt element (6) is formed by a plurality of shunt element portions (6a - 6c), wherein
- a first shunt element portion (6a) proceeding from the first current-carrying element (7) is oriented so as to extend radially with respect to the central axis (A) of the core element (2), in the direction of the inner periphery of the core element (2), wherein the first shunt element portion (6a) is connected to the first current-carrying element (7) and a second shunt element portion (6b),
- a second shunt element portion (6b) proceeding from the first shunt element portion (6a) is oriented so as to extend in the axial direction with respect to the central axis (A) of the core element (2), through the interior space defined by the inner periphery of the core element (2), wherein the second shunt element portion (6b) is connected to the first shunt element portion (6a) and a third shunt element portion (6c), and
- a third shunt element portion (6c) proceeding from the second shunt element portion (6b) is oriented so as to extend radially with respect to the central axis (A) of the core element (2), in the direction of the outer periphery of the core element (2), wherein the third shunt element portion (6c) is connected to the second shunt element portion (6b) and a second current-carrying element (8).

9. Current transformer device according to any of the preceding claims, **characterised in that** the shunt element portions (6a - 6c) forming the first shut element (6) are oriented so as to extend in a common plane.

10. Current transformer device according to claims 7 and 9, **characterised in that** the compensation element portions (10a - 10d) forming the compensation element (10), and the shunt element portions (6a - 6c) forming the first shunt element (6) are oriented so as to extend in a common plane or in parallel planes.

## Revendications

1. Système transformateur de courant (1), comprenant :
- un élément de noyau (2) réalisé à la manière d'un anneau ou avec une forme d'anneau,
- au moins un élément d'enroulement formant une partie d'un ensemble d'enroulement (4), dans lequel l'au moins un élément d'enroulement entoure au moins par endroits, en particulier en totalité, l'élément de noyau (2),
- un élément de compensation (10) réalisé à la manière d'un anneau ou en forme d'anneau, lequel est mis au point pour compenser des champs parasites, en particulier magnétiques, agissant sur le système transformateur de courant (1), dans lequel l'élément de compensation (10) est disposé selon un agencement spatial défini par rapport à l'élément de noyau (2) tout en entourant l'élément de noyau (2), en s'étendant le long de la périphérie intérieure et de la périphérie extérieure de l'élément de noyau (2), dans lequel l'élément de compensation (10) est un fil métallique formé à partir d'un matériau électriquement conducteur,
**caractérisé par**
- un premier élément de shunt (6) formant une partie d'un système de shunt (5), réalisé à la manière d'un U ou en forme de U, dans lequel le premier élément de shunt (6) est réalisé de manière à s'étendre par endroits à travers l'espace intérieur défini par la périphérie intérieure de l'élément de noyau (2),
- un autre élément de shunt (9) formant une autre partie du système de shunt (5), dans lequel l'autre élément de shunt (9) est disposé entre deux éléments d'acheminement de courant (7, 8) reliés au premier élément de shunt (6), dans lequel
le premier élément de shunt (6) et l'autre élément de shunt (9) forment une spire de shunt traversant côté intérieur l'élément de noyau (2) entouré par l'au moins un élément d'enroulement, dans lequel
la résistance électrique de l'élément de compensation (10) correspond à la résistance électrique de la spire de shunt.

2. Système transformateur de courant selon la revendication 1, **caractérisé en ce que** l'élément de compensation (10) est disposé sur la périphérie extérieure ou la périphérie intérieure ou, en particulier par l'entremise d'un élément de fixation, dans la zone de la périphérie extérieure ou de la périphérie intérieure de l'élément de noyau (2) entouré par l'au moins un élément d'enroulement ou est disposé sur un côté frontal ou, en particulier par l'entremise d'un élément de fixation, dans la zone d'un côté frontal de l'élément de noyau (2) entouré par l'au moins un élément d'enroulement.

3. Système transformateur de courant selon la revendication 1 ou 2, **caractérisé en ce que** l'élément de compensation (10) est formé par plusieurs, en particulier quatre, sections d'élément de compensation (10a - 10d), dans lequel
- une première section d'élément de compensation (10a) est orientée de manière à s'étendre dans une direction axiale par rapport à l'axe central (A) de l'élément de noyau (2) le long de la périphérie intérieure de l'élément de noyau (2), dans lequel la première section d'élément de compensation (10a) est reliée à une deuxième et à une quatrième section d'élément de compensation (10b, 10d),
- la deuxième section d'élément de compensation (10b) partant de la première section d'élément de compensation (10a) est orientée de manière à s'étendre dans la direction radiale par rapport à l'axe central (A) de l'élément de noyau (2) entre la périphérie intérieure et la périphérie extérieure de l'élément de noyau (2), dans lequel la deuxième section d'élément de compensation (10b) est reliée à la première et à une troisième section d'élément de compensation (10a, 10c),
- la troisième section d'élément de compensation (10c) partant de la deuxième section d'élément de compensation (10b) est orientée de manière à s'étendre dans la direction axiale par rapport à l'axe central (A) de l'élément de noyau (2) le long de la périphérie extérieure de l'élément de noyau (2), dans lequel la troisième section d'élément de compensation (10c) est reliée à la deuxième et à la quatrième section d'élément de compensation (10b, 10d),
la quatrième section d'élément de compensation (10d) partant de la troisième section d'élément de compensation (10c) est orientée de manière à s'étendre dans la direction radiale par rapport à l'axe central (A) de l'élément de noyau (2) entre la périphérie extérieure et la périphérie intérieure de l'élément de noyau (2), dans lequel la quatrième section d'élément de compensation (10d) est reliée à la troisième et à la première section d'élément de compensation (10a, 10c).

4. Système transformateur de courant selon la revendication 3, **caractérisé en ce que** l'élément de compensation (10) est fixé sur l'élément de noyau (2) par l'intermédiaire de la troisième section d'élément de compensation (10a).

5. Système transformateur de courant selon la revendication 3 ou 4, **caractérisé en ce que** la première, la deuxième et la quatrième section d'élément de compensation (10a, 10b, 10d) sont réalisées de manière à s'étendre respectivement à une certaine distance par rapport à l'élément de noyau (2), dans lequel celles-ci ne sont pas en contact avec l'élément de noyau (2).

6. Système transformateur de courant selon l'une quelconque des revendications 3 à 5, **caractérisé en ce que** la première et la troisième section d'élément de compensation (10a, 10c) sont orientées de manière à s'étendre de manière parallèle l'une par rapport à l'autre.

7. Système transformateur de courant selon l'une quelconque des revendications 3 à 6, **caractérisé en ce que** les sections d'élément de compensation (10a - 10d) formant l'élément de compensation (10) sont orientées de manière à s'étendre dans un plan commun.

8. Système transformateur de courant selon l'une quelconque des revendications précédentes, **caractérisé en ce que** le premier élément de shunt (6) est formé par plusieurs sections d'élément de shunt (6a - 6c), dans lequel
- une première section d'élément de shunt (6a) partant d'un premier élément d'acheminement de courant (7) est orientée de manière à s'étendre radialement par rapport à l'axe central (A) de l'élément de noyau (2) en direction de la périphérie intérieure de l'élément de noyau (2), dans lequel la première section d'élément de shunt (6a) est reliée au premier élément d'acheminement de courant (7) et à une deuxième section d'élément de shunt (6b),
- une deuxième section d'élément de shunt (6b) partant de la première section d'élément de shunt (6a) est orientée de manière à s'étendre dans la direction axiale par rapport à l'axe central (A) de l'élément de noyau (2) à travers l'espace intérieur défini par la périphérie intérieure de l'élément de noyau (2), dans lequel la deuxième section d'élément de shunt (6b) est reliée à la première section d'élément de shunt (6a) et à une troisième section d'élément de shunt (6c), et
- une troisième section d'élément de shunt (6c) partant de la deuxième section d'élément de shunt (6b) est orientée de manière à s'étendre radialement par rapport à l'axe central (A) de l'élément de noyau (2) en direction de la périphérie extérieure de l'élément de noyau (2), dans lequel la troisième section d'élément de shunt (6c) est reliée à la deuxième section d'élément de shunt (6b) et à un deuxième élément d'acheminement de courant (8).

9. Système transformateur de courant selon l'une quelconque des revendications précédentes, **caractérisé en ce que** les sections d'élément de shunt (6a - 6c) formant le premier élément de shunt (6) sont orientées de manière à s'étendre dans un plan commun.

10. Système transformateur de courant selon la revendication 7 et 9, **caractérisé en ce que** les sections d'élément de compensation (10a - 10d) formant l'élément de compensation (10) et les sections d'élément de shunt (6a - 6c) formant le premier élément de shunt (6) sont orientées de manière à s'étendre dans un plan commun ou dans des plans parallèles.
